Europäisches Patentamt

European Patent Office

Office européen des brevets

(11) Publication number: **0 065 406**
A2

# EUROPEAN PATENT APPLICATION

(21) Application number: 82302389.0

(22) Date of filing: 11.05.82

(51) Int. Cl.³: **H 03 H 9/08**, H 03 L 1/04

(30) Priority: 12.06.81 GB 8118218
13.05.81 GB 8114675

(43) Date of publication of application: 24.11.82
Bulletin 82/47

(84) Designated Contracting States: CH DE FR IT LI NL SE

(71) Applicant: MARCONI INSTRUMENTS LIMITED,
Longacres, St. Albans Hertfordshire, AL4 0JN (GB)

(72) Inventor: Maton, Gregory Waine, 16, Ennerdale Close,
St. Albans Hertfordshire (GB)

(74) Representative: Hoste, Colin Francis et al, Marconi
House New Street, Chelmsford Essex CM1 1PL (GB)

(54) **Frequency sources.**

(57)    A frequency source uses a temperature controlled crystal
to determine the frequency of an oscillator. An oscillator circuit
of which the crystal forms a part, and a temperature control cir-
cuit are mounted in very close proximity to the crystal so as to
minimise variations in its temperature. These two circuits and
the crystal are surrounded by a thermally insulating material
and enclosed in a relatively large container having temperature
controlled walls. The temperature of the walls is held at a value
which is less than the temperature of the crystal, but which is
significantly above the ambient temperature in which the frequency source is to be operated. To enable the walls of the
container to be held at constant temperature, the container is
mounted within a larger enclosure with further thermal insulat-
ing material being positioned between the container and the
enclosure.

## Frequency Sources

This invention relates to frequency sources of the kind which use a crystal to determine the frequency of an oscillator. The frequency of oscillation of a crystal is temperature dependent and it is usually necessary to carefully control the temperature of the crystal if a stable frequency having a precisely predetermined value is to be obtained. The present invention seeks to provide a frequency source which is capable of providing a particularly stable output frequency which is not significantly affected by changes in temperature of its environment.

According to this invention, a frequency source includes a crystal forming part of an oscillator circuit which determines the frequency of the frequency source, and wherein the crystal is held at a predetermined temperature by a heat source located closely adjacent to it; a container of good thermal conductivity within which the cyrstal is mounted so as to be spaced apart from the walls of the container; a plurality of temperature sensors in the form of self-regulating heaters positioned at different points on the container to minimise temperature variations therein and to maintain the container at a temperature which is less than the predetermined temperature of the crystal and which is greater than the ambient temperature in which the frequency source is to be operated, each temperature sensor comprising a body having a positive temperature co-efficient of resistance.

The invention is further described by way of example with reference to the accompanying drawings, in which

Figure 1 shows plan and elevation views of a frequency source in accordance with the invention,

Figures 2 and 3 are explanatory diagrams,

Figure 4 shows an oscillator circuit in which a crystal determines the frequency of oscillation,

Figure 5 shows a temperature control circuit which is operative to stabilise the temperature of the crystal.

It is possible to produce crystals which oscillate at a precisely constant frequency, provided the crystal is maintained at a fixed temperature. The value of the frequency is usually somewhat dependent on temperature, and although the temperature dependence of the frequency can be made very low, it is still nevertheless excessive for frequency sources which are required to exhibit a very precise and predetermined constant frequency regardless of variations in the ambient temperature in which the frequency source is to be operated. It is therefore often necessary to carefully monitor and control the frequency of the crystal.

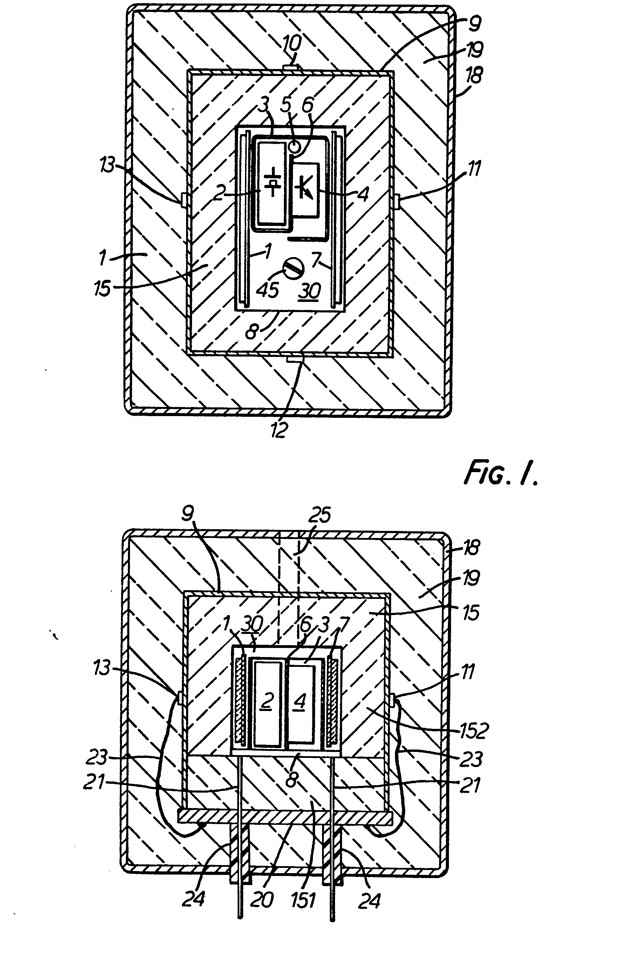

Referring to Figure 1, the lower drawing shows an elevation view of a frequency source and the upper drawing shows a plan view. The frequency source contains a crystal which operates at a precisely determined temperature.

A typical variation of frequency against temperature for a crystal is shown in Figure 2, and by way of example it is assumed that an oscillator circuit provides an output frequency of exactly 10 MHz at a crystal temperature of 75°C. It will be seen that the temperature characteristics of the crystal have been chosen with this operating frequency and temperature in mind, since the curve has a very shallow gradient at the temperature of interest. Thus even if the temperature varies slightly from the nominal value of 75°C, the resulting variation in frequency is slight. Even so, the temperature variation must be minimised so far as possible if a very stable frequency source is required, since even small frequency variations are unacceptable for certain purposes which have stringent frequency specifications.

Referring again to Figure 1, an oscillator circuit is formed on a ceramic substrate 1 and is mounted in close proximity to a crystal 2. The crystal 2 is held at a predetermined temperature by surrounding it with a thin copper foil 3 which acts as a thermal radiator, and which also surrounds a power transistor 4 which acts as a heat source, and a thermistor 5 which acts as a temperature sensor. The copper foil 3 has an excellent thermal conductivity so that temperature gradients in it are negligible. The transistor 4 is mounted in close proximity to a portion 6 of the foil which is positioned directly between the crystal 2 and the transistor 4. This serves to minimise the effect of temperature variations occurring on the surface of the transistor 4 itself, and further ensures that the crystal 2 is almost completely surrounded by the foil at an even temperature. The transistor 4 is operative to generate heat when the temperature as sensed by the thermistor 5 drops below a required and precisely predetermined value. The transistor 4 and the thermistor 5 both form part of a temperature control circuit which, like the oscillator circuit, is formed on a ceramic substrate 7 and is mounted in close proximity to the copper foil 3.

The two substrates 1 and 7, together with the crystal 2, the foil 3, the transistor 4 and the thermistor 5 are mounted on a rigid base 8 to form a compact and rigid assembly 30. This assembly 30 can be physically very small and, in practice, the base 8 is likely to be a printed circuit board which provides the necessary electrical interconnections between the various components of the frequency source. The space within the foil 3 is filled with a settable thermally conductive material which therefore encapsulates the crystal 2, the transistor 4 and the thermistor 5.

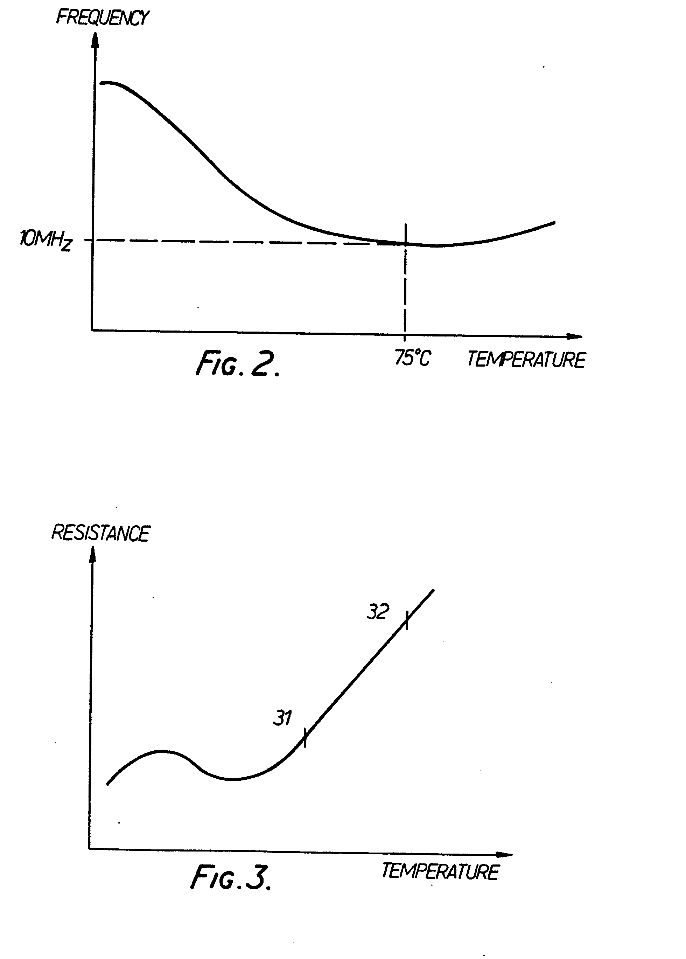

The assembly 30 is mounted within a container 9 which is in effect a thin walled closed box. The walls and roof of the container 9 are formed of a good conductive material such as copper, and its base 20 is formed of a robust electrically insulating material which provides support for the assembly 30. The container 9 is stabilised at a required temperature by means of four further thermistors 10, 11, 12 and 13. These further thermistors have positive temperature co-efficients of resistance, and differ from the thermistor 5 which has a negative temperature co-efficient. The characteristic of the thermistors 10, 11, 12 and 13 is shown in Figure 3, and they are arranged to operate on the linear portion of the characteristic between the points 31 and 32. These thermistors are connected in parallel across a power supply and they automatically stabilise the temperature of the container 9 at a predetermined temperature, as, if their temperature drops, it will be seen that their resistance decreases, and conversely their resistance increases with rising temperature. Assuming that the thermistors have a reasonably constant voltage drop across them equal to V volts, then the power dissipated is given by $V^2/R$. Thus as resistance R decreases, the power dissipation increases and hence their temperature rises. In this way the thermistors automatically stabilise at a temperature which is dictated primarily by the voltage applied to them.

Material 15, having very good thermally insulating properties, is present within the container 9 so as to surround the inner assembly on the printed circuit board 8. This material 15 is an expanded polyurethane which has a closed cell structure and therefore exhibits very good thermal insulating properties which assist the thermal stability of the assembly 30. The material 15 is formed in two portions; a flat portion 151 positioned between the base plate 20 and the printed circuit board 8, and a cap shape portion 152 which has a hollow rectangular recess which closely surrounds the assembly 30.

Container 9 is stabilised by the action of the thermistor 10, 11, 12, 13 so as to be held typically at a wall temperature of 55°C. This provides a significant temperature difference relative to the crystal 2, which is held at about 75°C, and enables a positive control to be exercised on the temperature of the crystal 2 by the transistor 4 relative to the container 9 under the influence of this temperature difference - the heating action of the transistor is counter balanced by heat flowing from the assembly 30. As it is desirable that the heat flow from the assembly to the container 9 shall be as constant as possible to minimise temperature variations, the container 9 is mounted in an outer enclosure 18 which may be of metal or it may be of a plastics material. This outer enclosure 18 adopts the ambient temperature of the surroundings in which the frequency source is located. Again, an expanded polyurethane insulating material 19 fills the space between the container 9 and the enclosure 18.

This expanded polyurethane is a rigid material and is sufficiently robust to support the internal parts of the frequency source without the need to provide separate mounting brackets to secure the container 9. However, the printed board 8 may be secured to the base plate 20 of the container 9 by means of rigid mounts 21, which could take the form of, for example, extended pins that also provide electrical connections to the outside of the unit and pass through insulating spacers 24. The electrical connections which must be made to the assembly 30 and to the thermistors located on the walls of the container 9 are made by means of flexible wires 23 which are embedded in the insulating material and which pass to connections on the base board 20. Further components that are required to select the operating temperature of the crystal are located on base plate 20.

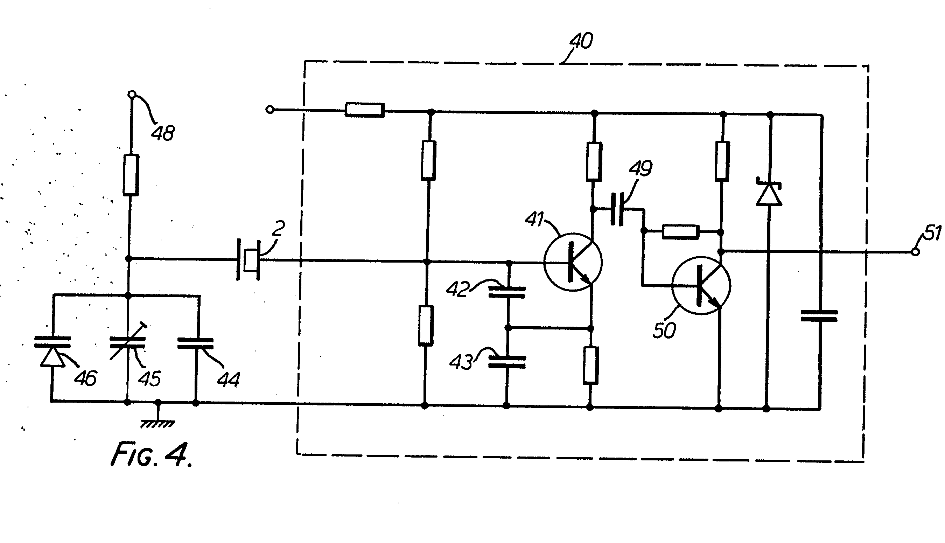

As previously mentioned, the oscillator circuit is formed on a ceramic substrate 1. This circuit together with the crystal 2 and its associated components are illustrated in Figure 4. Those parts of the circuit which are formed directly on the ceramic substrate are shown within the broken line 40. The oscillator itself consists of a transistor 41 and an associated feedback loop which includes capacitors 42 and 43. The crystal 2 is connected to the base of transistor 41 and also to an external circuit consisting of a fixed capacitor 44, an adjustable capacitor 45 and a varactor diode 46. The nature and properties of the crystal 2 primarily determine the frequency of oscillation, and a capacitor 44 which is consistent with the required frequency of oscillation is selected at the time the operating frequency is decided upon. It is unlikely that the oscillator will initially produce exactly the required frequency, and capacitor 45 is therefore adjusted until the correct frequency is achieved. Capacitor 45 is shown in Figure 1 and a passageway 25 is left in the insulating material so as to provide external access to enable the adjustment of capacitor 45 to be effected. Once the adjustment has been set, the passageway 25 is blocked with a plug of thermally insulating material. The varactor diode 46, which is essentially a variable capacitor whose capacitance can be varied by the application of a d.c potential, is present so that the frequency of oscillation can be subject to fine adjustment after the frequency source has been manufactured. This fine adjustment is applied by means of a variable voltage at terminal 48.

The output of transistor 41 is coupled via a small capacitor 49 to an amplifier 50 which provides an output signal which is compatible with TTL circuits at terminal 51 for utilisation as required. The remainder of the components shown in Figure 4 are merely conventional biassing and voltage stabilisation components which are usually associated with an oscillator.

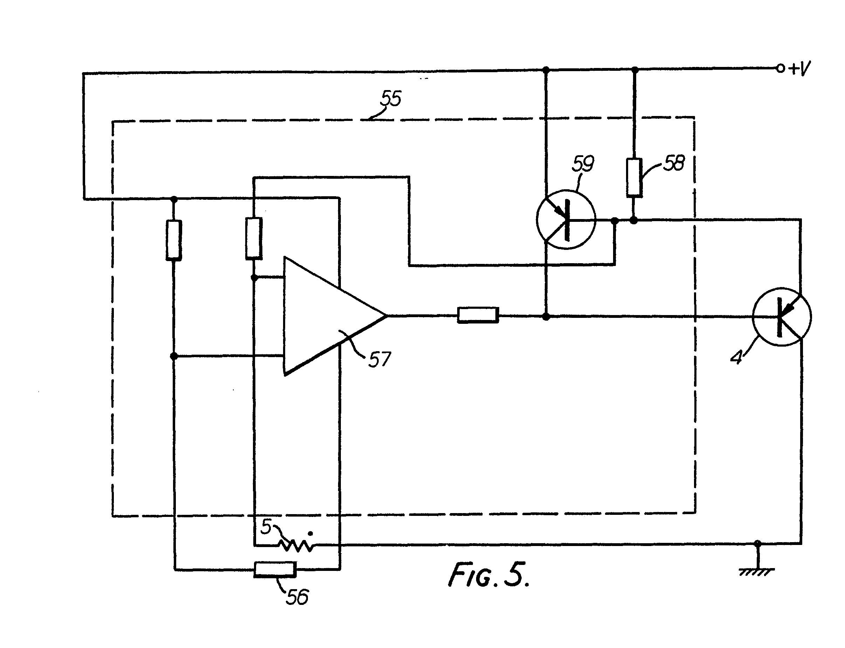

The temperature control circuit is shown in Figure 5 and those portions which are mounted on the substrate 7 are contained within the broken line 55. A resistor 56 is chosen in dependence on the operating temperature required, and it serves as a source of reference potential which is compared with the voltage drop across the thermistor 5. The thermistor 5 and the resistor 56 form part of a balanced bridge network which when unbalanced produces a difference signal which is amplified at a differential amplifier 57. The output of the amplifier 57 controls directly the current flowing through the power transistor 4 and hence the amount of heat which is applied to the radiating foil 3. A resistor 58, which is connected in series with the transistor 4, enables the current flowing through it to be monitored, so that current overload protection is provided by transistor 59, which is rendered conductive when the current flowing resistor 58 exceeds a safe value.

Once the temperature of the copper foil 3 has stabilised, the transistor 4 is unlikely to draw full power, but during the initial warm up period, the current overload protection transistor 59 is operative so as to prevent the transistor 4 drawing excessive current which might damage it or its associated circuitry. If it is desired to operate the crystal at a different temperature, it is merely necessary to replace the resistor 56 with one of a different value.

As both the oscillator circuit and the temperature control circuits are mounted on very stable ceramic substrates 1 and 7 which are held at the temperature of the copper foil 3, the whole assembly operates in an extremely stable manner and its temperature is not significantly affected by variations in the external ambient temperature in which the outer enclosure 18 is situated. The transistor 4 serves to raise the temperature of the crystal 2 when its temperature drops below a required value, and the temperature gradient between the crystal 2 and the container 9 ensures that the heat loss from the crystal does not fluctuate unduly.

Claims

1. A frequency source including a crystal forming part of an oscillator circuit which determines the frequency of the frequency source, and wherein the crystal is held at a predetermined temperature by a heat source located closely adjacent to it; a container of good thermal conductivity within which the crystal is mounted so as to be spaced apart from the walls of the container; a plurality of temperature sensors in the form of self-regulating heaters positioned at different points on the container to minimise temperature variations therein and to maintain the container at a temperature which is less than the predetermined temperature of the crystal and which is greater than the ambient temperature in which the frequency source is to be operated, each temperature sensor comprising a body having a positive temperature coefficient of resistance.

2. A frequency source as claimed in claim 1 and wherein each temperature sensor is connected across a substantially constant source of potential.

3. A frequency source as claimed in claim 1 or 2 and wherein the container has four walls each of which has substantially similar thermal properties, and a temperature sensor is mounted at, or about, the middle of each wall.

4. A frequency source as claimed in any of the preceding claims and wherein thermally insulating material is present between the crystal and said container.

5. A frequency source as claimed in claim 4 and wherein the thermally insulating material is one which has a closed cellular structure.

6. A frequency source as claimed in claim 1 and wherein said container is mounted within a larger container, so that in operation said container stabilises at a temperature which is higher than said larger container.

7. A frequency source as claimed in claim 6 and wherein said larger container is free to adopt the ambient temperature of its surroundings.

8. A frequency source as claimed in claim 6 or 7 and

0065406

wherein thermally insulating material is present between said
container and said larger container.

9.    A frequency source as claimed in claim 1 and wherein
the oscillator circuit and a temperature control circuit
are both mounted closely adjacent to the heat source so as
to be maintained at substantially the same temperature as the
crystal.

10.    A frequency source as claimed in claim 9 and wherein
major portions of the oscillator circuit and the temperature
control circuit are mounted on one or more ceramic substrates
which are in close proximity to a radiator of heat which
is arranged to be heated by said heat source.

1/4    0065406

FIG. 1.

FREQUENCY

10MHz

75°C   TEMPERATURE

*Fig. 2.*

RESISTANCE

32

31

TEMPERATURE

*Fig. 3.*

0065406

FIG. 4.

0065406

Fig. 5.